# EUROPÄISCHE PATENTANMELDUNG

(11) **EP 3 109 569 A1**
(43) Veröffentlichungstag der Anmeldung: **28.12.2016**
(21) Anmeldenummer: 16173794.5
(22) Anmeldetag: 09.06.2016
(51) Int. Cl.: F25B 21/02, H01L 35/30

(54) **TEMPERIEREINHEIT FÜR EIN GASFÖRMIGES ODER FLÜSSIGES MEDIUM**

(30) Priorität: 23.06.2015 AT 505312015
(71) Anmelder: AVL List GmbH, 8020 Graz (AT)
(72) Erfinder: Burazer, Vedran, 8045 Graz (AT); Buchner, Michael, 8010 Graz (AT)
(74) Vertreter: Patentanwälte Pinter & Weiss OG

(57) **Zusammenfassung**

Für eine Temperiereinheit für ein gasförmiges oder flüssiges Medium mit einer hochdynamische Temperaturregelung des Mediums ist die Temperiereinheit (1) mit einem Grundkörper (2) und einem Kühlkörper (5), zwischen denen eine Anzahl von thermoelektrischen Modulen (7) angeordnet sind, und mit einer Medienleitung (6) im Grundkörper (2) ausgeführt, und es ist vorgesehen, dass das Massenverhältnis der thermischen Speichermasse des Kühlkörpers (5) zur thermischen Speichermasse von Grundkörper (2) und darin angeordneter Medienleitung (6) im Bereich von 0,5 bis 1, vorteilhaft im Bereich von 0,7 bis 0,8, liegt.

## Beschreibung

Die gegenständliche Erfindung betrifft eine Temperiereinheit zum Temperieren eines gasförmigen oder flüssigen Mediums mittels einer Anzahl von thermoelektrischen Modulen, die zwischen einem Grundkörper und einem Kühlkörper angeordnet sind, und im Grundkörper eine Medienleitung angeordnet ist, durch die das gasförmige oder flüssige Medium durchströmt.

Zur exakten Messung des Kraftstoffverbrauchs eines Verbrennungsmotors auf einem Prüfstand ist eine genaue Konditionierung der Temperatur und des Druckes des dem Verbrennungsmotor zugeführten Kraftstoffes notwendig. Die Messung des Kraftstoffverbrauchs erfolgt dabei oftmals mit einem bekannten Coriolis-Durchflusssensor. Ein Beispiel für eine solche Messung des Kraftstoffverbrauchs ist in der US 2014/0123742 A1 zu finden, die auf die Konditionierung von flüssigen Kraftstoffen abstellt. Darin wird die Temperatur des Kraftstoffes über einen Wärmetauscher mit einer Kühlflüssigkeit geregelt. Starke Lastwechsel verursachen starke Schwankungen im Kraftstoffverbrauch und in der Medientemperatur des Rücklaufs (Eingangstemperatur). Ein solcher Wärmetauscher ist aber träge und lässt nur langsame Temperaturänderungen zu. Damit ist die beschriebene Konditionierung mittels Wärmetauscher für starke Lastwechsel (Eingangstemperaturänderungen) ungeeignet. Dies führt beim aktuellen Stand der Technik dazu, dass nach einem derartigen Lastwechsel eine Beruhigungszeit eingehalten werden muss. Während dieser Zeit ist die Temperatur nicht stabil und für Durchflusssensoren ist keine hochpräzise Messung möglich. Für einen von den Eingangstemperaturänderungen unabhängigeren Betrieb müsste entweder die Leistungsdichte des Wärmetauschers erhöht werden. Dies ist aber nicht so ohne weiteres technisch realisierbar und erfordert, falls überhaupt möglich, ein Redesign des Wärmetauschers. Bei gleichbleibender Leistungsdichte ergäbe sich wiederum einen erheblich größeren Platzbedarf. Eine weitere Möglichkeit bestünde möglicherweise in einem aggressiveren Regelverhalten des Wärmetauschers. Dies bedeutet aber wiederum größeres Über- und Unterschwingen und damit einhergehend eine schlechtere Dynamik hinsichtlich möglicher Solltemperaturänderungen. Den Wärmetauscher zu vergrößern würde aber auch nur bei Flüssigkeiten helfen. Bei gasförmigen Medien bewirkt eine Durchflussänderung unmittelbar eine Druckänderung und eine Solltemperaturänderung. Damit müsste der Wärmetauscher extrem schnelle Solltemperaturänderungen ermöglichen, was aber für einen mit Kühlflüssigkeit betriebenen Wärmetauscher nicht praktikabel realisierbar ist. Dazu müsste die zur Verfügung stehende Leistung bei gleichbleibender Masse noch weiter erhöht werden, ausschließlich die Leistung zu erhöhen hätte in diesem Fall keinen Nutzen. Alternativ bleibt noch den Regler des Wärmetauschers noch aggressiverer einzustellen, was aber wiederum noch größeres Über- und Unterschwingen nach sich ziehen würde. Eine genaue und schnelle Temperaturregelung wäre damit nicht möglich.

Die dynamische Temperaturregelung mittels eines Wärmetauschers, wenn also keine konstante Temperatur einzustellen ist, ist daneben noch relativ ungenau. Abgesehen davon bedingt ein solcher Wärmetauscher zusätzliche Bauteile und Steuerungen zum Betreiben des Wärmetauschers, was die Anlage auch aufwendiger macht.

In der DE 10 2010 046 946 A1 ist vorgeschlagen, die Temperatur des Kraftstoffes in einer Konditionieranlage mittels thermoelektrischer Module (sogenannte Peltierelemente) zu temperieren. Damit ist aufgrund der erzielten geringen Speichermassen eine hoch dynamische Temperaturregelung möglich, mit der der Kraftstoff sowohl geheizt, als auch gekühlt werden kann. Auch diese Vorrichtung zielt speziell auf die Konditionierung flüssiger Kraftstoffe ab.

Bei gasförmigen Kraftstoffen, wie Erdgas oder Wasserstoff, tritt das zusätzliche Problem auf, dass der gasförmige Kraftstoff in der Regel unter hohem Druck vorliegt bzw. geliefert wird und folglich für die Verwendung als Kraftstoff in einem Verbrennungsmotor zuerst auf einen benötigten, niedrigeren Druck entspannt werden muss. Beim Entspannen des gasförmigen Kraftstoffes, wie beispielsweise Erdgas, kühlt sich der Kraftstoff aber stark ab, was für nachfolgende Komponenten der Konditionieranlage problematisch sein kann, beispielsweise durch Kondensatbildung und das Vereisen der Gasleitungen oder anderen Komponenten in der Gasleitung. Daher wird der gasförmige Kraftstoff vor dem Entspannen in der Regel erwärmt, sodass sich durch das Entspannen eine erwünschte Temperatur des Kraftstoffes ergibt. Aufgrund von Schwankungen im Druck des zugeführten gasförmigen Kraftstoffes und auch aufgrund der Abhängigkeit der Temperatur nach dem Entspannen von der Zusammensetzung des gasförmigen Kraftstoffes, die ebenfalls variieren kann, muss die Temperaturregelung des gasförmigen Kraftstoffes vor dem Entspannen hochdynamisch sein, um die Temperatur nach dem Entspannen und vor der Durchflussmessung konstant halten zu können. Darüber hinaus ist die benötigte Heizleistung zum Temperieren des Kraftstoffes auch stark vom aktuellen Durchfluss abhängig, was bei sich rasch ändernden Durchflüssen ebenfalls eine hochdynamische Temperaturregelung erforderlich macht.

Eine solche hochdynamische Temperaturregelung bedingt zum einen ein Regelverfahren, das in der Lage ist hochdynamische (im Sinne schneller Temperaturänderungen) Regeleingriffe durchzuführen und zum anderen eine Temperiereinheit, die in der Lage ist, die hochdynamischen Regeleingriffe auch umzusetzen. Eine solche Temperiereinheit muss folglich in der Lage sein, dem durchströmenden Kraftstoff in sehr kurzer Zeit die benötigten Temperaturänderungen einzuprägen. Daneben ist auch eine hohe Temperaturstabilität erwünscht, auch dann, wenn unter Umständen keine hohen Anforderungen an die Dynamik der Temperaturregelung gestellt werden, da in gewissen Anwendungen eine hochgenaue und hochkonstante Temperaturregelung benötigt wird. Diese Anforderungen bedingen eine Temperiereinheit mit einer hohen Heiz- und Kühlleistung, wobei unter Umständen auch rasch zwischen Heizen und Kühlen gewechselt werden muss. Abgesehen davon muss damit auch eine genaue Temperaturregelung möglich sein, um ein zu starkes Übertemperieren (entweder Überheizen oder Unterkühlen) zu vermeiden.

Die DE 10 2010 046 946 A1 gibt den Hinweis, dass für eine hochdynamische Temperaturregelung geringe thermische Speichermassen der Temperiereinheit vorteilhaft sind.

Die US 6,502,405 B1 zeigt ein Wärmetauscherelement mit Peltierelementen zum Heizen oder Kühlen von Kraftstoff in einem Fahrzeug. Das Wärmetauscherelement besteht aus einem Wärmeleitblock in dem eine Kraftstoffleitung mäanderförmig eingelegt ist und die auf einer ersten Seite thermisch isoliert ist. An der zweiten Seite des Wärmeleitblocks sind Peltierelemente angeordnet, die thermisch mit einem Kühlkörper verbunden sind. Der Kühlkörper ist typischerweise mit einer großen Oberfläche und mit kleiner Speichermasse ausgeführt, um die Wärmeableitkapazität zu maximieren. Zusätzlich ist am Kühlkörper noch ein Ventilator angeordnet, um die Wärmeableitkapazität noch weiter zu erhöhen. Damit ist das Wärmetauscherelement der US 6,502,405 B1 auch auf eine geringe thermische Speichermasse ausgelegt, um Wärme über den Kühlkörper rasch an die Umgebung abführen zu können. Durch die mäanderförmige Führung des Kraftstoffes im Wärmetauscherelement kommt es aber auch zu einer ungleichmäßigen Erwärmung des Kraftstoffes, was die Temperaturregelung erschwert, da die Peltierelemente alle mit der gleichen Versorgungsspannung angesteuert werden. Aus der ungleichmäßigen Erwärmung ergibt sich eine höhere Temperaturdifferenz zwischen der Austrittstemperatur des Mediums und der Oberfläche der Peltierelemente, was wiederum zu einer niedrigeren maximalen Austrittstemperatur des Mediums führt, da die Peltierelemente nicht beliebig erhitzt werden können. Oder es ergibt sich eine niedrigere maximale Durchflussmenge bei vorgegebener Austrittssolltemperatur. Abgesehen davon wird durch die höhere Temperaturdifferenz mehr thermische Energie im Wärmeleitblock gespeichert, die im Falle einer Solltemperaturänderung wieder abgebaut werden muss, was das Wärmetauscherelement aber wiederum träger macht. Für eine gleichmäßigere Erwärmung des Kraftstoffes, müssten die einzelnen Peltierelemente entweder aufeinander abgestimmt sein, d.h. unterschiedliche Peltierlemente entlang der Kraftstoffleitung, oder die Peltierelemente müssten einzeln versorgt und geregelt werden. Beides wäre aber sehr aufwendig und daher nachteilig.

Die oben angeführten Probleme können aber grundsätzlich bei jedem gasförmigen oder flüssigen Medium, das in einer Temperiereinheit temperiert werden soll, und nicht nur bei Kraftstoff auftreten.

Ausgehend von diesem Stand der Technik ist es eine Aufgabe der gegenständlichen Erfindung eine Temperiereinheit für ein gasförmiges oder flüssiges Medium anzugeben, die eine besonders hochdynamische und genaue Temperaturregelung des Mediums ermöglicht.

Diese Aufgabe wird erfindungsgemäß dadurch gelöst, dass das Massenverhältnis der thermischen Speichermasse des Kühlkörpers zur thermischen Speichermasse von Grundkörper und darin angeordneter Medienleitung im Bereich von 0,5 bis 1, vorteilhaft im Bereich von 0,7 bis 0,8, liegt und ganz besonders vorteilhaft mit 0,75 gewählt wird.

Es hat sich gezeigt, dass für eine hochdynamische Temperaturregelung eines Mediums mittels einer Temperiereinheit nach dem Oberbegriff von Anspruch 1, insbesondere wenn eine rasche und oftmalige Änderung der Richtung des Wärmeflusses erforderlich ist, eine zu geringe Speichermasse, wie vom Stand der Technik nahe gelegt, nachteilig ist. Überraschender Weise wurde festgestellt, dass für die Temperaturregelung ein gewisses Massenverhältnis zwischen der Masse des Kühlkörpers und der Masse des Grundkörpers samt der darin angeordneten Medienleitung vorteilhaft ist. Der Grund dafür liegt offenbar darin, dass durch die größere Masse des Kühlkörpers eine thermische Speichermasse ausgebildet wird und damit nicht zu schnell thermische Energie an die Umgebung abgegeben wird. Diese gespeicherte Energie kann dann verwendet werden, um gegebenenfalls beim Erwärmen des Kraftstoffes zu unterstützen, womit die Temperierung rascher und genauer erfolgen kann.

Eine kompakte Ausgestaltung der Temperiereinheit ergibt sich, wenn im Grundkörper eine Nut vorgesehen ist, in die die Medienleitung eingepresst ist.

Für eine sehr effiziente Temperierung ist es vorteilhaft, wenn die Medienleitung im Grundkörper spiralförmig von außen nach innen geführt angeordnet ist. Durch diese Anordnung der Medienleitung im Grundkörper in Form einer eingängigen Spirale kann eine besonders gleichmäßige und effiziente Temperierung des Mediums erreicht werden. Durch die Spiralform kann die Temperiereinheit sehr kompakt ausgeführt werden, da die Spiralgänge eng nebeneinander angeordnet werden können. Damit kann ein thermoelektrischer Modul auch mehrere Spiralgänge überdecken, was die Effizienz der Temperiereinheit und die Gleichmäßigkeit der Erwärmung verbessert. Damit kann eine besonders hochdynamische, genaue und stabile Temperaturregelung des Mediums erzielt werden.

Eine effiziente Temperierung wird weiters unterstützt, wenn die Anzahl der thermoelektrischen Module in mehreren, umfangsförmig ausgerichteten Reihen am Grundkörper angeordnet sind, wobei die Modulheizleistung eines radial weiter außen liegenden thermoelektrischen Moduls größer ist, als die Modulheizleistung eines radial weiter innen liegenden thermoelektrischen Moduls. Damit kann das von außen zuströmende Medium im radial äußeren Bereich mit hoher Heizleistung temperiert werden, was starke und rasche Temperaturänderungen ermöglicht. Die Module werden dabei vorzugsweise so aufeinander abgestimmt, dass die Temperaturspreizung bei Maximaldurchfluss zwischen Modul-Oberfläche und Medium Austrittstemperatur minimal wird. Wie sich gezeigt hat, ist das der Fall wenn alle Module nahezu die gleiche Oberflächentemperatur aufweisen. Durch die umfangsförmige Anordnung sind die thermoelektrischen Module innerhalb einer Reihe von Haus aus nahezu auf der gleichen Temperatur. Lediglich die unterschiedlichen Reihen müssten diesbezüglich abgeglichen werden, was im Gegensatz zu einer mäanderförmigen Anordnung der Medienleitung eine wesentliche Vereinfachung darstellt, da für das gleiche Ergebnis (minimale Temperaturspreizung) nicht mehr alle thermoelektrischen Module abgeglichen werden müssen.

Außerdem kann die Modulheizleistung optimal an die Bedingungen angepasst werden und es können radial innen Module mit kleinerer Modulheizleistung verbaut werden.

Um die thermische Energie im Grundkörper zu konzentrieren und einen zu starken Abfluss von thermischer Energie zu verhindern, ist der Grundkörper vorteilhafter Weise von einem Grundkörpermantel umgeben, wobei über den Umfang des Grundkörpers eine Mehrzahl von radialen Verbindungsstegen angeordnet sind, die mit dem Grundkörpermantel verbunden sind. Das erhöht ebenfalls die Effizienz der Temperiereinheit. Das kann noch weiter verbessert werden, wenn der Grundkörpermantel teilweise hohl ausgeführt ist, da damit eine noch bessere thermische Isolation zwischen Grundkörper und Umgebung erreicht wird.

Es kann vorteilhaft sein, im Kühlkörper eine Kühlleitung anzuordnen, durch die bedarfsweise Kühlmedium zum Kühlen des Kühlkörpers fließt, um Wärme schneller vom Kühlkörper abführen zu können. Das kann insbesondere bei Gasen ohne ausgeprägten Joule-Thomson Effekt oder bei flüssigen Medien nützlich sein, da in diesen Fällen ein oftmaliges Umpolen der thermoelektrischen Module notwendig sein kann. Die Kühlleitung wird dabei vorteilhaft wieder spiralförmig angeordnet.

Die gegenständliche Erfindung wird nachfolgend unter Bezugnahme auf die Figuren 1 bis 7 näher erläutert, die beispielhaft, schematisch und nicht einschränkend vorteilhafte Ausgestaltungen der Erfindung zeigen. Dabei zeigt
Fig.1 eine perspektivische Ansicht der erfindungsgemäßen Temperiereinheit,
Fig.2 eine Ansicht der Temperiereinheit bei abgenommenen Kühlkörper,
Fig.3 und 4 Ansichten des Grundkörpers der Temperiereinheit,
Fig.5 eine Ansicht der Medienleitung in der Temperiereinheit,
Fig.6 eine weitere vorteilhafte Anordnung der Medienleitung im Grundkörper und
Fig.7 eine Temperiereinheit mit einer Kühlleitung im Kühlkörper.

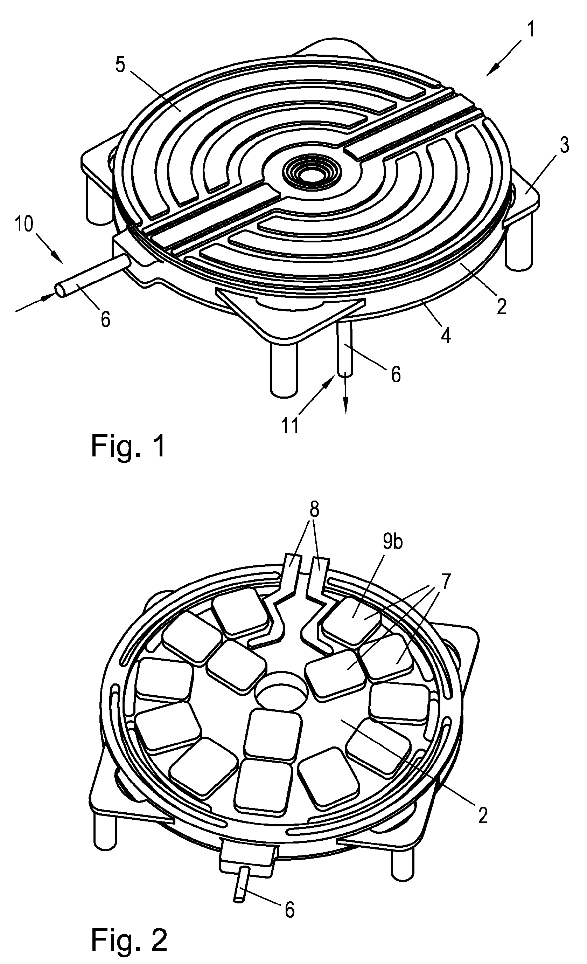

In Fig.1 ist eine perspektivische Ansicht der erfindungsgemäßen Temperiereinheit 1 dargestellt. Die Temperiereinheit 1 besteht aus einem Grundkörper 2, an dem auch beliebige Befestigungselemente 3, wie z.B. Füße im gezeigten Ausführungsbeispiel, zum Befestigen der Temperiereinheit 1 vorgesehen sein können. An einer ersten Seite des Grundkörpers 2 ist ein thermisches Isolationselement 4 angeordnet und an der gegenüberliegenden zweiten Seite ein Kühlkörper 5. Durch die Temperiereinheit 1 ist eine Medienleitung 6 durchgeführt, durch die ein gasförmiges oder flüssiges Medium, wie z.B. Kraftstoff, strömt, der in der Temperiereinheit 1 auf eine gewünschte Temperatur temperiert wird. Die Medienleitung 6 weist hierzu einen Eingangsanschluss 10 und einen Ausgangsanschluss 11 auf, womit auch die Strömungsrichtung des Mediums durch die Temperiereinheit 1 festgelegt ist (angedeutet in Fig.1 durch die Pfeile).

In der Fig.2 ist die Temperiereinheit 1 mit abgenommenen Kühlkörper 5 dargestellt. Darin erkennt man eine Anzahl von thermoelektrischen Modulen (Peltierelemente) 7, die am Grundkörper 2 angeordnet sind. Ein thermoelektrisches Modul 7 ist bekanntermaßen ein Halbleiterelement, das zwischen einer ersten (hier dem Grundkörper 2 zugewandten) Heizfläche 9a (nicht sichtbar in Fig.2) und einer zweiten (hier dem Kühlkörper zugewandten) Heizfläche 9b angeordnet ist. Je nach Polarität der dem Halbleiterelement zugeführten elektrischen Spannung ist entweder die erste Heizfläche 9a wärmer als die zweite Heizfläche 9b, oder umgekehrt. Nachdem der Aufbau und die Funktion solcher thermoelektrischen Module 7 hinreichend bekannt sind und solche thermoelektrischen Module 7 kommerziell in verschiedenen Leistungsklassen erhältlich sind, wird hier nicht näher darauf eingegangen.

Damit kann mit einem solchen thermoelektrischen Modul 7 je nach Polarität der Versorgungsspannung, die beispielsweise über die Anschlüsse 8 zugeführt wird, sowohl geheizt, als auch gekühlt werden. "Heizen" bedeutet hier, dass dem Grundkörper 2 Wärme zugeführt wird und "Kühlen", dass dem Grundkörper 2 Wärme entzogen wird. Damit kann mit den thermoelektrischen Modulen 7 der Wärmefluss zwischen dem Grundkörper 2 und dem Kühlkörper 5 beeinflusst werden.

Die thermoelektrischen Module 7 sind dabei über eine erste Heizfläche 9a (in Fig.2 nicht sichtbar) direkt oder indirekt (beispielsweise über ein Wärmeübertragungselement zur Verbesserung der Wärmeleitung) in thermischen Kontakt mit dem Grundkörper 2. Der Kühlkörper 5 ist an der zweiten Heizfläche 9b des thermoelektrischen Moduls angeordnet und steht in thermisch leitenden Kontakt, wieder direkt oder indirekt, mit dieser zweiten Heizfläche 9b. Der Kühlkörper 5 und der Grundkörper 2 sind nicht aneinander liegend angeordnet, um einen direkten thermisch leitenden Kontakt zwischen Kühlkörper 5 und Grundkörper 2 zu vermeiden (wie in Fig.1 ersichtlich).

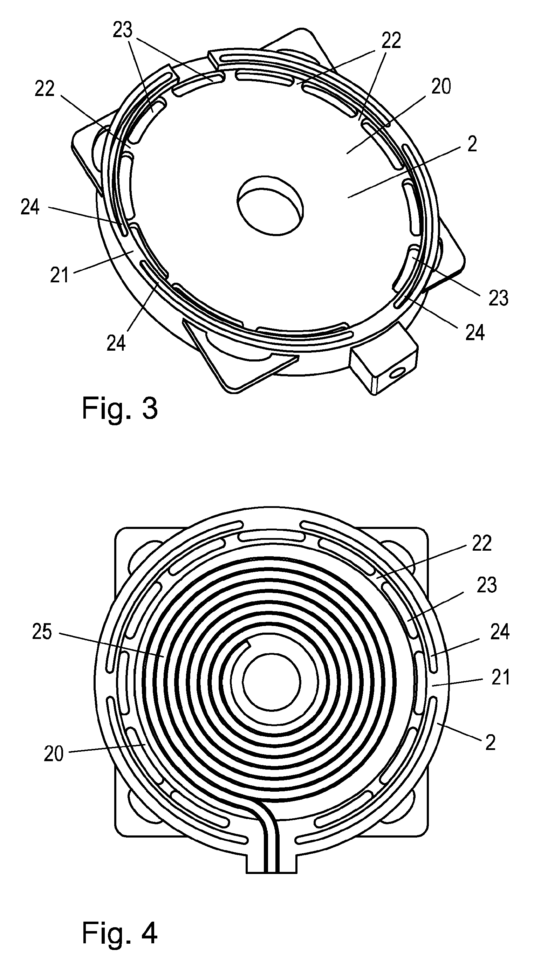

Der Grundkörper 2 ist in Detail in den Fig.3 und 4, die unterschiedliche Ansichten des Grundkörpers 2 zeigen, dargestellt. Fig.3 zeigt die Seite des Grundkörpers 2, an der die thermoelektrischen Module 7 angeordnet sind. Der Grundkörper 2 wird im Wesentlichen aus einer Grundplatte 20 gebildet, die entlang deren Umfanges von einem Grundkörpermantel 21 umgeben wird. Der Grundkörpermantel 21 ist dabei über radiale Verbindungsstege 22 mit der Grundplatte 20 verbunden, wobei die Verbindungsstege 22 über den Umfang der Grundplatte 20 verteilt angeordneten sind. In Umfangsrichtung zwischen den Verbindungsstegen 22 werden dadurch Hohlräume 23 ausgebildet, die als thermische Isolation zwischen Grundplatte 2 und Grundkörpermantel 21 fungieren. Durch die Verbindungsstege 22 und die Hohlräume 23 wird der Wärmefluss von der Grundplatte 20 in den Grundkörpermantel 21 erheblich verringert. Dadurch bleibt die von den thermoelektrischen Modulen 7 in die Grundplatte 20 eingebrachte Wärme in dieser konzentriert und fließt nur in geringem Maße über den Grundkörpermantel 21 an die Umgebung ab. Damit wird gleichzeitig auch erreicht, dass sich der Grundkörpermantel 21, und damit auch die Temperiereinheit 1, an der Außenseite nicht zu stark erhitzen, und dass parasitäre Wärmeströme, die die Leistung und Dynamik der Konditionierung verringern, so klein wie möglich gehalten werden.

Der Grundkörpermantel 21 kann zusätzlich teilweise hohl ausgeführt sein, indem in den Grundkörpermantel 21 Umfangsschlitze 24 eingearbeitet sind, die ebenfalls Hohlräume zur zusätzlichen thermischen Isolation ausbilden.

In Fig.4 ist die andere Seite des Grundkörpers 2 gezeigt. Hier ist zu erkennen, dass an der Rückseite der Grundplatte 20 eine vorzugsweise spiralförmige Nut 25 eingeformt ist, in die im zusammengebauten Zustand die Medienleitung 6 eingepresst ist. Die Nut 25 bildet dabei im Grundkörper 2 eine eingängige ebene Spirale (Archimedische Spirale, logarithmische Spirale) aus. Die Medienleitung 6 wird dabei vorzugsweise von außen spiralförmig nach innen geführt und tritt im zentral inneren Bereich der Grundplatte 20 aus der Temperiereinheit 1 aus, wobei die Medienleitung 6 beim Austritt aus der Ebene der Spirale heraus umgelenkt wird, bevorzugt um ca. 90°, um die Medienleitung 6 einfach aus der Temperiereinheit 1 herausführen zu können. Grundsätzlich ist aber auch jede andere Führung der Medienleitung 6 im Grundkörper 20 denkbar.

Die Verwendung einer Medienleitung 6 in Form einer eingängigen Spirale ist fertigungstechnisch sehr aufwendig, da sich die Medienleitung 6 in diesem Fall in alle drei Dimensionen erstreckt.

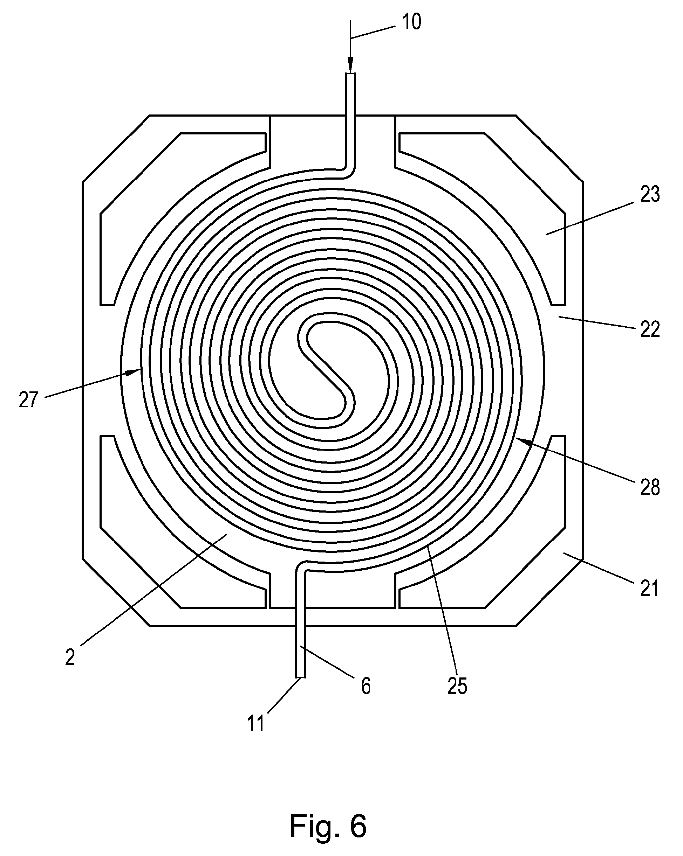

In einer alternativen Ausgestaltung ist die Medienleitung 6 am Grundkörper 2 in Form einer zweigängigen ebenen Spirale (auch Fermat'sche Spirale genannt) angeordnet, wie anhand von Fig.6 beschrieben wird. Dazu kann im Grundkörper 2 wiederum eine entsprechend geformte Nut 25 zur Aufnahme der Medienleitung 6 eingeformt sein. Über einen ersten Spiralgang 27 wird das Medium in der Medienleitung 6 spiralförmig radial von außen nach zentral innen geführt. Zentral innen ist der erste Spiralgang 27 mit einem zweiten Spiralgang 28 verbunden, über den das Medium in der Medienleitung 6 spiralförmig von radial innen nach radial außen geführt wird. Durch die zweigängige Ausführung der Nut 25 liegen radial immer ein erster Spiralgang 27 und ein zweiter Spiralgang 28 nebeneinander. Das Medium wird damit radial außen über den Eingangsanschluss 10 zugeführt und radial außen über den Ausgangsanschluss 11 abgeführt. Die zweigängige Spirale hat den Vorteil, dass die Medienleitung 6 nicht aus der Ebene der Spirale umgelenkt werden muss, was fertigungstechnisch einfacher ist. Dafür hat die zweigängige Spirale den Nachteil, dass das einfließende Medium das ausfließende Medium kühlt, womit etwas mehr Leistung benötigt wird und eine weniger gleichmäßige Erwärmung realisierbar ist. Die Temperaturspreizung wird dabei größer, aber die thermoelektrischen Module einer Reihe haben, im Falle abgestimmter Module, nach wie vor alle annähernd dieselbe Temperatur.

Die eingängige oder zweigängige Spirale muss dabei natürlich nicht unbedingt als Kreisspirale ausgeführt sein, sondern kann auch anderen Formen, wie rechteckförmig, quadratisch, usw., aufweisen. Durch die Spiralform kann die Temperiereinheit 1 sehr kompakt gebaut werden, da die Spiralgänge eng nebeneinander angeordnet werden können. Damit kann auf kleinem Raum viel Laufmeter an Medienleitung 6 untergebracht werden, was die verfügbare Oberfläche zur Temperierung des durch die Medienleitung 6 fließenden Mediums erhöht.

Um eine dichte Packung der Medienleitung 6 realisieren zu können, dürfen bei der Formgebung der Medienleitung 6 vorgeschriebene minimale Biegeradien nicht unterschritten werden. Eine mäanderförmige Führung der Medienleitung wäre diesbezüglich nachteilig, da die erforderlichen Biegeradien für eine dichte Packung erheblich kleiner sind als bei einem spiralförmigen Verlauf. Bei steigenden Druckanforderungen seitens der Medienleitung 6 steigt aufgrund der erforderlichen Wandstärkenerhöhung in der Regel auch der minimale Biegeradius. Eine mäanderförmige Führung wirkt sich daher bei hohen Druckanforderungen, wie im gegenständlichen Fall, besonders nachteilig aus.

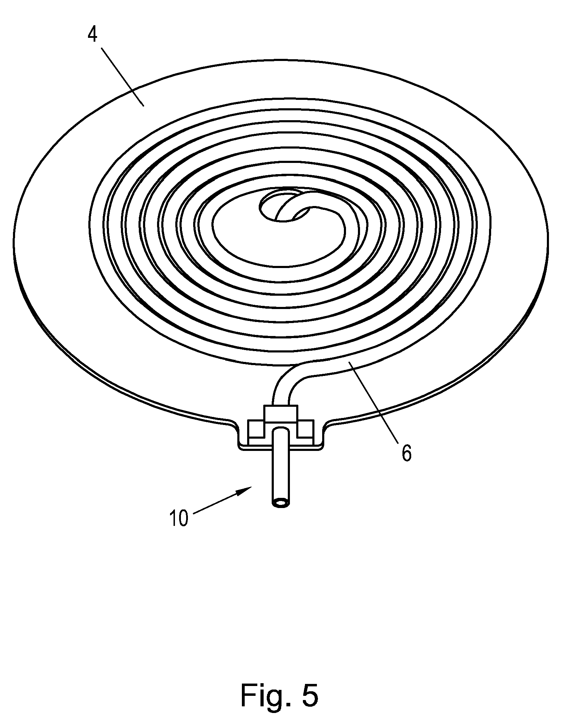

Fig.5 zeigt noch das thermische Isolationselement 4 mit der vorteilhaft eingängig spiralförmigen Medienleitung 6, die im zusammengebauten Zustand in den Grundkörper 20 eingepresst ist. Durch das thermische Isolationselement 4 wird erreicht, dass die von den thermoelektrischen Modulen 7 in die Grundplatte 20 eingebrachte Wärme in dieser konzentriert bleibt und nicht über die Stirnseite der Temperiereinheit 1 an die Umgebung abgegeben wird.

Die thermoelektrischen Module 7 sind vorzugsweise kreisförmig, bzw. an die Spiralform angepasst, und in mehreren Reihen (also in verschiedenen radialen Abständen) an der Grundplatte 20 angeordnet (Fig.2). Damit können radial außen aufgrund des sich ergebenden größeren Umfangs mehr thermoelektrische Module 7 angeordnet werden. Das zuströmende Medium wird damit im radial äußeren Bereich mit hoher Heizleistung temperiert, was starke und rasche Temperaturänderungen ermöglicht. Dabei ist es weiters vorteilhaft, wenn ein thermoelektrisches Module 7, das radial weiter innen angeordnet ist, eine geringere Modulheizleistung hat, als ein thermoelektrisches Module 7, das radial weiter außen angeordnet ist. Nachdem die Medienleitung 6 bevorzugt eingängig spiralförmig nach innen geführt ist, reichen radial innen weniger und schwächere (im Sinne von weniger Modulheizleistung) thermoelektrische Module 7 zur Temperierung des Mediums aus. Damit kann die Temperierung des Mediums auch durch die Anordnung und Auswahl der Modulheizleistung der einzelnen thermoelektrischen Module 7 optimiert werden und es kann eine sehr gleichmäßige Erwärmung des Mediums erzielt werden.

Wird an ein thermoelektrisches Modul 7 eine elektrische Versorgungsspannung angelegt, so wird bekanntermaßen eine der Heizflächen 9a, 9b des thermoelektrischen Moduls 7 abgekühlt, während sich gleichzeitig die gegenüberliegende Heizfläche 9a, 9b erwärmt. Die maximale Temperaturspreizung zwischen den Heizflächen 9a, 9b hängt von der Betriebstemperatur (Temperatur an der wärmeren Heizfläche) des thermoelektrischen Moduls 7 ab. Je höher die Betriebstemperatur, desto höher ist die maximale erreichbare Temperaturspreizung zwischen kalter und heißer Heizfläche 9a, 9b. Dadurch können mit verfügbaren thermoelektrischen Modulen 7 Temperaturen von bis zu 200°C an der heißen Heizfläche erreicht werden, wobei die kalte Heizfläche 100°C nicht überschreitet. Durch einfaches Umpolen der Versorgungsspannung wird eine hochdynamische Regelung der Temperatur ermöglicht. Diese Regelung wird in der erfindungsgemäßen Temperiereinheit 1 unterstützt, indem der Kühlkörper 5 im Heizbetrieb, also wenn das Medium in der Medienleitung 6 erwärmt werden soll, als Pufferspeicher verwendet wird. Dazu ist die thermische Speichermasse aber nicht möglichst klein auszuführen, wie im Stand der Technik nahe gelegt, sondern es ist eine gewisse Speichermasse erwünscht, um das realisieren zu können.

Hierbei hat es sich als vorteilhaft herausgestellt, wenn das Massenverhältnis der thermischen Speichermasse des Kühlkörpers 5 zur thermischen Speichermasse von Grundkörper 2 und darin angeordneter Medienleitung 6 im Bereich von 0,5 bis 1, vorteilhaft 0,7 bis 0,8, gewählt wird. Eine ganz besonders vorteilhafte Temperaturregelbarkeit der Temperiereinheit 1 wurde bei einem Massenverhältnis im Bereich von 0,75, bzw. bei einem Massenverhältnis von 0,75, festgestellt. Eine getestete Temperiereinheit 1 hatte beispielsweise eine thermische Speichermasse des Kühlkörpers 5 von 5,4kg und eine thermische Speichermasse von Grundkörper 2 und darin angeordneter Medienleitung 6 von 7,2kg, womit sich ein Massenverhältnis von 0,75 ergab.

In einer Ausführung wie in Fig.3 oder Fig.6, bei der der Grundkörpermantel 21 über Hohlräume 23 thermisch vom Grundkörper 2 getrennt ist, wird die Masse des Grundkörpermantels 21 nicht zur thermischen Speichermasse des Grundkörpers gerechnet. Ebenso ist das Isolationselement 4 nicht Teil der thermischen Speichermasse des Grundkörpers 2.

Bei konstantem Heizbedarf der Temperiereinheit 1, also bei konstanter Spannungsversorgung der thermoelektrischen Module 7, stellt sich an den thermoelektrischen Modulen 7 eine stabile Temperaturspreizung ein. Sobald nun weniger thermische Energie bzw. Wärme zum Temperieren des Mediums benötigt wird, wird die Versorgungsspannung an den thermoelektrischen Modulen 7 reduziert, womit auch die Temperaturspreizung geringer wird. Damit sinkt die Temperatur an der an der Grundplatte 20 anliegenden Heizfläche 9a des thermoelektrischen Moduls 7. Gleichzeitig steigt die Temperatur an der gegenüberliegenden Heizfläche 9b. Es entsteht damit ein Temperaturgradient zwischen der Heizfläche 9b und dem daran anliegenden Kühlkörper 5, wodurch Wärme in den Kühlkörper 5 fließt und dort aufgrund der thermischen Speichermasse des Kühlkörper 5 nicht sofort an die Umgebung abgeführt wird, sondern (zumindest für eine begrenzte Zeit) zwischengespeichert wird. Diese zwischengespeicherte thermische Energie steht der Temperaturregelung bzw. der Temperiereinheit 1 als Unterstützung zur Verfügung, wenn wieder mehr thermische Energie zum Temperieren des Mediums benötigt wird. In diesem Fall würde die Versorgungsspannung wieder angehoben werden, womit die Temperaturspreizung an den thermoelektrischen Modulen 7 wieder ansteigt. Damit sinkt die Temperatur an der Heizfläche 9b, an der der Kühlkörper 5 anliegt, gegenüber der Temperatur des Kühlkörpers 5 ab. Dadurch entsteht ein umgekehrter Temperaturgradient, der dazu führt, dass im Kühlkörper 5 gespeicherte thermische Energie (Wärme) in den Grundkörper 2 fließt und somit die thermoelektrischen Module 7 unterstützt. Aufgrund der thermischen Speichermasse des Kühlkörpers 5 kann damit mit der Temperiereinheit 1 auf Lastwechsel bzw. Temperaturänderungen sehr schnell und präzise reagiert werden und ein typisches Übertemperieren kann weitestgehend vermieden werden. Hierzu darf die thermische Speichermasse des Kühlkörpers 5 gegenüber der thermischen Speichermasse von Grundkörper 2 und darin angeordneter Medienleitung 6 aber nicht zu groß oder zu klein sein.

Die Gesamtoberfläche des Kühlkörpers 5 sollte dabei in Abhängigkeit von der zu erwartenden Betriebstemperatur so gestaltet werden, dass die im Kühlkörper 5 gespeicherte Wärme nicht zu rasch an die Oberfläche abgegeben wird, sondern ausreichend lange im Kühlkörper 5 gespeichert bleibt. Die Oberfläche ist damit nicht wie bei herkömmlichen Kühlkörpern so groß wie möglich und optimiert auf die Abführung der Wärme zu dimensionieren, sondern im Gegenteil so, dass die Wärme im Kühlkörper 5 gespeichert bleibt.

Eine vollständige thermische Isolierung des Kühlkörpers 5 von der Umgebung wäre ebenfalls nachteilig, da im Falle häufiger Umpolungen sich die Temperatur im Kühlkörper 5 aufschaukeln könnte.

Für verschiedene Medien sind gegebenenfalls das Material der Medienleitung 6 und die Heizleistung der thermoelektrischen Module 7 anzupassen. Das allgemeine Grundprinzip mit dem Kühlkörper 5 als Speichermasse zur Unterstützung der Temperiereinheit 1 bleibt dabei aber unberührt.

Für bestimmte gasförmige Medien, wie z.B. Erdgas, kommt es aufgrund des Joule Thomson Effekt zu einer starken Abkühlung durch die notwendige Druckentspannung. Bei diesen Gasen muss die Temperiereinheit 1 das gasförmige Medium in der Regel nur vorwärmen. Ein Abkühlen dieser Gase durch die Temperiereinheit 1 ist in der Regel nicht erforderlich. Damit reicht es für diese Anwendungen normalerweise auch aus, nur mit der Temperaturspreizung der thermoelektrischen Module 7 zu arbeiten. Ein Umpolen um von Heizen auf Kühlen zu wechseln ist eher nicht notwendig.

Andere gasförmige Medien, wie z.B. Wasserstoff, zeigen diesen ausgeprägten Effekt der starken Abkühlung durch die notwendige Druckentspannung nicht. Ganz im Gegenteil kann es durch die Druckentspannung auch zu einer Erwärmung kommen. Bei der Temperierung von flüssigen Medien ist oftmals keine Druckentspannung notwendig, da das flüssige Medium schon mit richtigem Druck vorliegt.

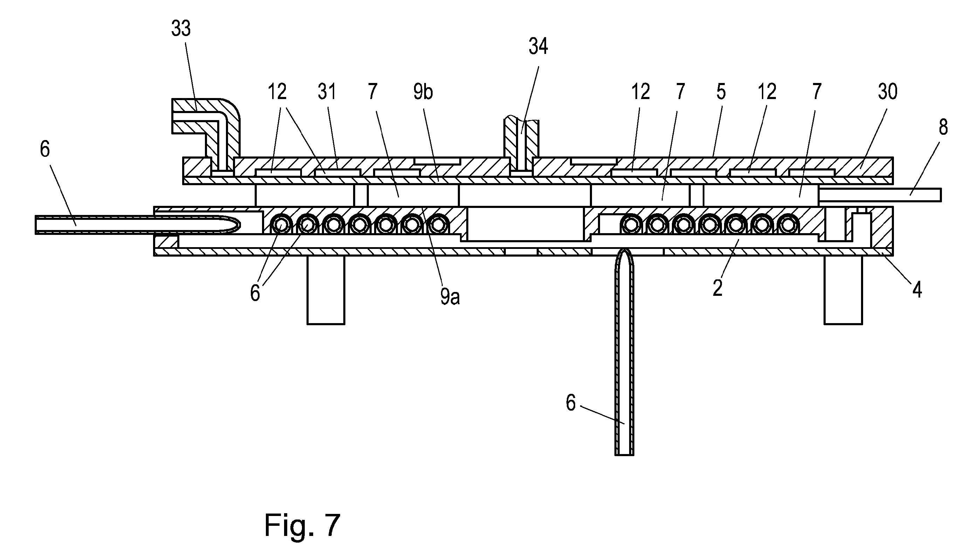

Bei Gasen ohne ausgeprägten Joule Thomson Effekt oder bei flüssigen Medien muss die Temperiereinheit 1 daher auch oftmals zwischen Heizen und Kühlen das gasförmigen Mediums umschalten, um die Temperatur abhängig vom Druck und dem Durchfluss konstant zu halten. Insbesondere beim Kühlen kann es aber sein, dass aufgrund der geringeren Oberfläche des Kühlkörpers 5 die entstehende Wärme, insbesondere auch die Abwärme der thermoelektrischen Module 7, nicht rasch genug abgeführt werden kann. Daher kann bei Verwendung der Temperiereinheit 1 mit solchen gasförmigen oder flüssigen Medien auch vorgesehen sein, den Kühlkörper 5 bedarfsweise zusätzlich zu kühlen. Dazu kann in den Kühlkörper 5 eine Kühlleitung 12 eingebracht sein, durch die Kühlflüssigkeit zur zusätzlichen Kühlung des Kühlkörpers 5 geleitet wird. Eine solche Ausführung ist in Fig.7 angedeutet. Die Kühlleitung 12 kann im Kühlkörper 5 wiederum in Form einer eingängigen oder zweigängigen Spirale, wie oben bzgl. der Medienleitung 6 beschrieben, angeordnet sein. Dazu kann der Kühlkörper 5 auch mehrteilig ausgeführt sein, um die Kühlleitung 12 einbringen zu können. Selbstverständlich sind aber auch andere Ausführungen der Kühlleitung 12 denkbar.

Im gezeigten Ausführungsbeispiel nach Fig.7 sind in einem Kühlkörpergrundkörper 30 Nuten 31 eingearbeitet, beispielsweise eingefräst, um die Kühlleitung 12 auszubilden. Die Nuten 31 sind vorzugswiese wie beschrieben spiralförmig eingearbeitet. Der Kühlkörpergrundkörper 30 mit den Nuten 31 wird mit einem Kühlkörperdeckel 32 abgedeckt, um den Kühlkörper 5 auszubilden.

Falls eine eigene Leitung als Kühlleitung 12 in den Kühlkörper 5 eingesetzt wird (ähnlich wie die Medienleitung 6 im Grundkörper), dann wäre die Kühlleitung 12 auch Teil der thermischen Speichermasse des Kühlkörpers 5.

Um an die Kühlleitung 12 im Kühlkörper 5 anschließen zu können, kann am Kühlkörper ein Kühlmediumzuführanschluss 34 und ein Kühlmediumabführanschluss 33 vorgesehen sein. Vorzugsweise wird das Kühlmedium von innen zugeführt und zentral außen abgeführt.

## Patentansprüche

1. Temperiereinheit zum Temperieren eines gasförmigen oder flüssigen Mediums mittels einer Anzahl von thermoelektrischen Modulen (7), die zwischen einem Grundkörper (2) und einem Kühlkörper (5) angeordnet sind, und im Grundkörper (2) eine Medienleitung (6) angeordnet ist, durch die das gasförmige oder flüssige Medium durchströmt, **dadurch gekennzeichnet, dass** das Massenverhältnis der thermischen Speichermasse des Kühlkörpers (5) zur thermischen Speichermasse von Grundkörper (2) und darin angeordneter Medienleitung (6) im Bereich von 0,5 bis 1, vorteilhaft im Bereich von 0,7 bis 0,8, liegt.

2. Temperiereinheit nach Anspruch 1, **dadurch gekennzeichnet, dass** das Massenverhältnis 0,75 ist.

3. Temperiereinheit nach Anspruch 1, **dadurch gekennzeichnet, dass** im Grundkörper (2) eine Nut (25) vorgesehen ist, in die die Medienleitung (6) eingepresst ist.

4. Temperiereinheit nach Anspruch 1 oder 3, **dadurch gekennzeichnet, dass** die Medienleitung (6) im Grundkörper (2) spiralförmig von außen nach innen geführt angeordnet ist.

5. Temperiereinheit nach Anspruch 1 oder 3, **dadurch gekennzeichnet, dass** die Medienleitung (6) im Grundkörper (2) in Form einer zweigängigen Spirale in einem ersten Spiralgang (27) von außen nach innen und in einem zweiten Spiralgang (28), der radial innen an den ersten Spiralgang (27) anschließt, von innen nach außen geführt angeordnet ist.

6. Temperiereinheit nach Anspruch 4 oder 5, **dadurch gekennzeichnet, dass** die Anzahl der thermoelektrischen Module in mehreren Reihen am Grundkörper (2) angeordnet sind, wobei die Modulheizleistung eines radial weiter außen liegenden thermoelektrischen Moduls (7) größer ist, als die Modulheizleistung eines radial weiter innen liegenden thermoelektrischen Moduls (7).

7. Temperiereinheit nach Anspruch 1, **dadurch gekennzeichnet, dass** der Grundkörper (2) von einem Grundkörpermantel (21) umgeben ist, wobei über den Umfang des Grundkörpers (2) eine Mehrzahl von radialen Verbindungsstegen (22) angeordnet sind, die mit dem Grundkörpermantel (21) verbunden sind.

8. Temperiereinheit nach Anspruch 7, **dadurch gekennzeichnet, dass** der Grundkörpermantel (21) teilweise hohl ausgeführt ist.

9. Temperiereinheit nach Anspruch 1, **dadurch gekennzeichnet, dass** im Kühlkörper (5) eine Kühlleitung (12) angeordnet ist, durch die bedarfsweise Kühlmedium zum Kühlen des Kühlkörpers (5) fließt.

10. Temperiereinheit nach Anspruch 9, **dadurch gekennzeichnet, dass** die Kühlleitung (12) spiralförmig angeordnet ist.
